# EUROPÄISCHE PATENTSCHRIFT

(11) **EP 1 083 778 B1**
(45) Veröffentlichungstag und Bekanntmachung des Hinweises auf die Patenterteilung: **17.11.2004**
(21) Anmeldenummer: 00116763.4
(22) Anmeldetag: 03.08.2000
(51) Int. Cl.: H05K 1/11, H05K 3/34, H05K 3/32

(54) **Verfahren zum Bestücken einer Leiterplatte**
Process for mounting components on a printed circuit board
Procédé de montage de composants sur un panneau à circuit imprimé

(30) Priorität: 07.09.1999 DE 19942631
(43) Veröffentlichungstag der Anmeldung: 14.03.2001
(73) Patentinhaber: Endress + Hauser GmbH + Co. KG., 79689 Maulburg (DE)
(72) Erfinder: Birgel, Dietmar, 79650 Schopfheim (DE); Hauptvogel, Karl-Peter, 68870 Bartenheim (FR)
(74) Vertreter: Andres, Angelika

(56) Entgegenhaltungen:
- EP-A- 0 717 587
- US-A- 4 787 853
- US-A- 5 255 431
- US-A- 5 402 314
- US-A- 5 926 375
- PATENT ABSTRACTS OF JAPAN vol. 014, no. 130 (E-0901), 12. März 1990 (1990-03-12) & JP 01 321681 A (NEC CORP), 27. Dezember 1989 (1989-12-27)
- PATENT ABSTRACTS OF JAPAN vol. 018, no. 188 (E-1532), 31. März 1994 (1994-03-31) & JP 05 347416 A (FUJITSU LTD), 27. Dezember 1993 (1993-12-27)
- PATENT ABSTRACTS OF JAPAN vol. 013, no. 437 (E-826), 29. September 1989 (1989-09-29) & JP 01 164089 A (IBIDEN CO LTD), 28. Juni 1989 (1989-06-28)
- PATENT ABSTRACTS OF JAPAN vol. 1997, no. 06, 30. Juni 1997 (1997-06-30) & JP 09 051160 A (KITAGAWA IND CO LTD), 18. Februar 1997 (1997-02-18)
- PATENT ABSTRACTS OF JAPAN vol. 015, no. 506 (E-1148), 20. Dezember 1991 (1991-12-20) & JP 03 220792 A (NEC CORP), 27. September 1991 (1991-09-27)
- PATENT ABSTRACTS OF JAPAN vol. 018, no. 299 (E-1558), 8. Juni 1994 (1994-06-08) & JP 06 061419 A (HITACHI LTD), 4. März 1994 (1994-03-04)
- PATENT ABSTRACTS OF JAPAN vol. 016, no. 022 (E-1156), 20. Januar 1992 (1992-01-20) & JP 03 237796 A (SHIBAURA ENG WORKS CO LTD), 23. Oktober 1991 (1991-10-23)
- PATENT ABSTRACTS OF JAPAN vol. 1998, no. 06, 30. April 1998 (1998-04-30) & JP 10 051093 A (HITACHI AIC INC), 20. Februar 1998 (1998-02-20)

## Beschreibung

Die Erfindung bezieht sich auf ein Verfahren zum Bestücken einer Leiterplatte mit einem elektronischen Bauteil, das zumindest zwei Kontaktierungen aufweist. Auf der Leiterplatte selbst ist zumindest eine Leiterbahn angeordnet.

Es ist eine Tatsache, daß die Zahl der im Bereich der Bestückung von Leiterplatten verwendeten bedrahtete Bauteile rückläufig ist. Dennoch wird es auch in Zukunft stets einen -wenn auch geringen- Anteil an bedrahteten Bauteilen geben, die nicht als SMD-Varianten erhältlich sind. Die Bestückung von Leiterplatten mit diesen bedrahteten Bauteilen erforderte bislang immer zumindest einen zusätzlichen Arbeitsgang: Entweder wurden die bedrahteten Bauteile nach Aufbringen der SMD-Bauteile von Hand, mittels eines Wellenlötprozesses oder durch Einpressen in spezielle Bohrungen auf der Leiterplatte befestigt. Diese Verfahren laufen der angestrebten Rationalisierung insbesondere im Bereich der Massenfertigung entgegen.

Aus JP-A-03237796 und JP-A-10051093 sind Verfahren zum Bestücken von Leiterplatten bekannt, wobei in den Leiterplatten erzeugte Durchgangsbohrungen von auf den Unterseiten der Leiterplatten angebrachten Schichten verschlossen werden.

Der Erfindung liegt die Aufgabe zugrunde, ein Verfahren vorzuschlagen, mit dem eine Leiterplatte kostengünstig als eine mischbestückte Baugruppe gefertigt werden kann. Mischbestückt ist im Rahmen der vorliegenden Erfindung stets so zu verstehen, daß auf der Leiterplatte neben anderen Bauteilen, z. B. neben SMD-Bauteilen, zumindest ein bedrahtetes Bauteil befestigt wird. Bei dem bedrahteten Bauteil handelt es sich beispielsweise um einen Winkelstecker, um einen Drehschalter, um ein Relais, eine Steckerleiste oder einen SMA-Stecker. Weitere Aufgabe ist es, ein Verfahren vorzuschlagen, mit dem die gemeinsame und gleichzeitige Herstellung der elektrischen Verbindung von SMD-Bauteilen und dem bedrahteten Bauteil mit der Leiterplatte möglich ist.

Das Verfahren gemäß der Erfindung ist im Anspruch 1 definiert.

Gemäß dem erfindungsgemäßen Verfahren wird die Leiterplatte an den gewünschten Stellen durchbohrt; die Bohrung wird mit einer leitfähigen Beschichtung versehen; ein Endbereich einer jeden Bohrung mit einem thermisch beständigen Material verschlossen; anschließend werden die Kontaktierungen des elektronischen Bauteils in die nunmehr gebildeten Sacklochbohrungen eingebracht und mit den Sacklochbohrungen leitend verbunden. Gegenüber der ersten Ausgestaltung hat diese Variante den Vorteil, daß Bohrungen in bereits nach gewissen Standards gefertigten Leiterplatten für die Durchführung des erfindungsgemäßen Verfahrens aufbereitet und verwendet werden können.

Der Vorteil des Verfahrens ist - abgesehen von der kosten- und zeitsparenden Fertigung - darin zu sehen, daß Leiterplatten problemlos auch im Bereich der bedrahteten Bauteile beidseitig bestückt werden können; der erforderliche Platzbedarf läßt sich also minimieren, was der fortschreitenden Miniaturisierung und erhöhten Packungsdichte der Leiterplatten natürlich entgegenkommt. So schlägt auch eine Weiterbildung beider Ausführungsformen vor, daß die Leiterplatte beidseitig mit den elektronischen Bauteilen bestückt wird.

Gemäß einer vorteilhaften Weiterbildung beider erfindungsgemäßer Lösungsvarianten ist vorgesehen, daß in die Sacklochbohrungen ein Lotwerkstoff, z.B. SnPb, SnAg und SnBi, eingebracht wird und daß die Kontaktierungen mit der leitfähigen Beschichtung auf den Innenflächen der Sacklochbohrungen nachfolgend über ein Reflow-Verfahren verbunden werden. Alternativ ist vorgesehen, daß die Kontaktierungen mit der leitfähigen Beschichtung auf den Innenflächen der Sacklochbohrungen mittels eines Leitklebers verbunden werden.

Die Erfindung wird anhand der nachfolgenden Zeichnung näher erläutert. Es zeigt:
Fig. 1: einen Schnitt durch eine Leiterplatte und
Fig. 2: einen Schnitt durch eine Leiterplatte, die nach dem erfindungsgemäßen Verfahren gefertigt ist.

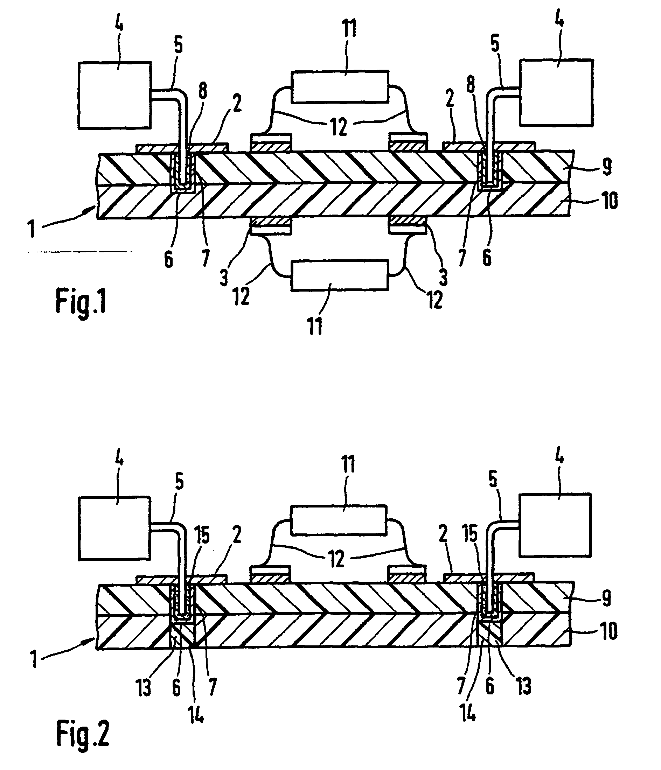

Fig. 1 zeigt im Schnitt eine Leiterplatte 1 mit einer dielektrischen Schicht 9 und mit zwei Leiterbahnen 2, 3, wobei die beiden Leiterbahnen 2, 3 zu beiden Seiten der dielektrischen Schicht 9 angeordnet sind. Die Leiterplatte 1 ist mischbestückt: Sie trägt sowohl zwei SMD-Bauteile 11, die über Kontaktierungen 12 mit der Leiterbahn 2 verbunden sind, als auch zwei bedrahtete Bauteile 4. Die beiden bedrahteten Bauteile 4 sind auf der Leiterplatte 1 festgemacht.
Gemäß diesem Verfahren werden Sacklochbohrungen 6 in die Leiterplatte 1 eingebracht. Die Innenflächen der Sacklochbohrungen 6 werden anschließend mit einer leitfähigen Beschichtung 7 versehen. Diese leitfähige Beschichtung 7 kann aus mehreren Materialschichten zusammengesetzt sein, wobei vorzugsweise die äußere leitfähige Schicht 7 aus Gold gefertigt ist. In jede mit einer leitfähigen Beschichtung 7 versehene Sacklochbohrung 6 wird zuerst ein Lotwerkstoff 8 und dann die entsprechende Kontaktierung 5 des bedrahteten Bauteils 4 eingebracht. Sowohl durch das Einfügen der Kontaktierungen 5 in die Sacklochbohrungen 6 als auch durch das Einbringen der Kontaktierungen 5 in den Lotwerkstoff 8 wird eine relativ beständige Vorfixierung des bedrahteten Bauteils 4 auf der Leiterplatte 1 erzielt.

In einem letzten Verfahrensschritt werden die vorfixierten bedrahteten Bauteile 4 endgültig mit der Leiterplatte 1 verbunden. Diese Verbindung erfolgt im Falle der Verwendung eines Lotwerkstoffes 8 mittels eines Reflow-Verfahrens. Beim Reflow-Verfahren wird der Lotwerkstoff 8 bei Temperaturen über dessen Schmelzpunkt - bei SnPb ca. 215° - verflüssigt und benetzt die Oberfläche der Kontaktierung 5 zumindest teilweise. Beim Erkalten erstarrt der Lotwerkstoff 8 und stellt nachfolgend eine innige elektrische und mechanische Verbindung zwischen der leitfähigen Beschichtung 7 auf der Innenfläche einer Sacklochbohrung 6 und der eingefügten Kontaktierung 5 des bedrahteten Bauteils 4 her. Die elektrische Verbindung zwischen der Kontaktierung 5 und der leitfähigen Beschichtung 7 auf der Innenfläche der Sacklochbohrung 6 kann auch mittels eines Leitklebers 15 erfolgen. Üblicherweise werden Leitkleber 15 bei relativ niedrigen Temperaturen ausgehärtet.

Fig. 2 zeigt einen Schnitt durch eine Leiterplatte 1, die nach dem erfindungsgemäßen Verfahren gefertigt ist. Die nachfolgende Beschreibung beschränkt sich im wesentlichen darauf, die Unterschiede zu der ersten Verfahrensvariante herauszustellen. Die Leiterplatte 1 setzt sich übrigens aus zwei dielektrischen Schichten 9, 10 zusammen.
Gemäß dieser zweiten Variante werden die Sacklochbohrungen 6 folgendermaßen erzeugt: die Leiterplatte 1 wird an gewünschten Stellen durchbohrt; nach Aufbringen der leitfähigen Beschichtung 7 wird der eine Endbereich 13 mit einem thermisch beständigen Material 14 verschlossen. Durch diese Ausgestaltung wird es möglich - wie bereits an vorhergehender Stelle erwähnt - Standard-Leiterplatten mit Durchbohrungen für die erfindungsgemäße Befestigung der bedrahteten Bauteile 4 zu verwenden. In die derart gefertigten Sacklochbohrungen 6 wird der Lotwerkstoff 8 bzw. der Leitkleber 15 und die jeweilige Kontaktierung 5 eingebracht.

### Bezugszeichenliste

- 1: Leiterplatte
- 2: erste Leiterbahn
- 3: zweite Leiterbahn
- 4: bedrahtetes Bauteil
- 5: Kontaktierung
- 6: Sacklochbohrung
- 7: leitfähige Beschichtung
- 8: Lotwerkstoff/Leitkleber
- 9: erste dielektrische Schicht
- 10: zweite dielektrische Schicht
- 11: SMD-Bauteil
- 12: Kontaktierung
- 13: Endbereich
- 14: thermisch beständiges Material
- 15: Leitkleber

## Patentansprüche

1. Verfahren zum Bestücken einer Leiterplatte (1), auf der zumindest eine Leiterbahn (2; 3) angeordnet ist, mit einem elektronischen Bauteil (4), das zumindest zwei Kontaktierungen (5) aufweist,
wobei die Leiterplatte (1) durchbohrt wird,
wobei ein thermisch beständiges Material (14) in einen Endbereich (13) der durchgehenden Bohrungen eingebracht wird, wodurch der Endbereich (13) verschlossen wird und aus den durchgehenden Bohrungen Sacklochbohrungen (6) werden,
wobei die Innenflächen der Sacklochbohrungen (6) mit einer leitfähigen Beschichtung (7) versehen werden,
wobei die Kontaktierungen (5) in die Sacklochbohrungen (6) eingebracht werden und
wobei die Kontaktierungen (5) mit den Sacklochbohrungen (6) leitend verbunden werden.

2. Verfahren nach Anspruch 1,
wobei in die Sacklochbohrungen (6) ein Lotwerkstoff (8) eingebracht wird und
wobei die Kontaktierungen (5) mit der leitfähigen Beschichtung (7) auf den Innenflächen der Sacklochbohrungen (6) über ein Reflow-Verfahren verbunden werden.

3. Verfahren nach Anspruch 1,
wobei die Kontaktierungen (5) mit der leitfähigen Beschichtung (6) auf den Innenflächen der Sacklochbohrungen (6) mittels eines Leitklebers (15) verbunden werden.

4. Verfahren nach Anspruch 1, 2 oder 3,
wobei die Leiterplatte (1) beidseitig mit den elektronischen Bauteilen (4; 11) bestückt wird.

## Claims

1. A method of assembling a printed circuit board (1) on which at least one conductor track (2; 3) is placed, with an electronic component (4) which comprises at least two contact means (5),
wherein the printed circuit board (1) is bored through,
wherein a heat-resistant material (14) is inserted into an end region (13) of the through-bores, as a result of which the end region (13) is closed and blind bores (6) are formed from the through-bores,
wherein the inner faces of the blind bores (6) are provided with a conductive coating (7),
wherein the contact means (5) are inserted into the blind bores (6), and
wherein the contact means (5) are connected to the blind bores (6) in a conductive manner.

2. A method according to Claim 1,
wherein a soldering material (8) is inserted into the blind bores (6), and
wherein the contact means (5) are connected to the conductive coating (7) on the inner faces of the blind bores (6) by means of a reflow method.

3. A method according to Claim 1,
wherein the contact means (5) are connected to the conductive coating (7) on the inner faces of the blind bores (6) by means of a conductive adhesive (15).

4. A method according to Claim 1, 2 or 3,
wherein the printed circuit board (1) is provided with the electronic components (4; 11) on both sides.

## Revendications

1. Procédé pour recouvrir une carte de circuit imprimé (1) sur laquelle est disposée au moins un conducteur (2, 3) avec un élément (4) électronique qui présente au moins deux contacts (5),
la carte de circuit imprimé (1) étant transpercée,
un matériau (14) résistant à la chaleur étant installé dans une zone terminale (13) des alésages de passage ; la zone terminale (13) étant fermée et des alésages de passages étant transformés en trous borgnes (6),
les surfaces intérieures des trous borgnes (6)étant pourvus d'un revêtement (7) conducteur,
les contacts (5) étant logés de façon conductrice dans les trous borgnes (6) et
les contacts (5) étant reliés de façon conductrice avec les trous borgnes (6).

2. Procédé selon la revendication 1, dans lequel une matière de brasage (8) est logée dans les trous borgnes (6) et dans lequel les contacts (5) sont reliés au revêtement (7) conducteur par un procédé de refusion sur les surfaces intérieures des trous borgnes (6).

3. Procédé selon la revendication 1, dans lequel les contacts (5) sont reliés au revêtement (6) conducteur sur les surfaces intérieures des trous borgnes (6).

4. Procédé selon la revendication 1, 2 ou 3, dans lequel la carte de circuit imprimé (1) est revêtue des deux côtés avec les éléments (4; 11) électroniques.
